# EUROPEAN PATENT APPLICATION

(11) **EP 1 154 478 A2**
(43) Date of publication of application: **14.11.2001**
(21) Application number: 00308479.5
(22) Date of filing: 27.09.2000
(51) Int. Cl.: H01L 23/495, H01L 23/31, H01L 21/56

(54) **Sheet-like board member, lead frame, and manufacture of a semiconductor device**

(30) Priority: 09.05.2000 JP 2000135284
(71) Applicant: SANYO ELECTRIC CO., LTD., Moriguchi-shi, Osaka 570-0083 (JP)
(72) Inventor: Sakamoto, Noriaki, Yamada-gun, Gunma (JP); Kobayashi, Yoshiyuki, Oura-gun, Gunma (JP); Sakamoto, Junji, Ota-shi, Gunma (JP); Mashimo, Shigeaki, Seta-gun, Gunma (JP); Okawa, Katsumi, Ota-shi, Gunma (JP); Maehara, Eiju, Kiryu-shi, Gunma (JP); Takahashi, Kouji, Sawa-gun, Gunma (JP)
(74) Representative: Nicholls, Michael John

(57) **Abstract**

By means of use of a sheet-like board member 50 having conductive coating films 51 which are formed in the form of the pattern of leads on a second surface 53, or use of a lead frame having protuberances formed in the form of the pattern of leads 56 on the second surface 53, a pitch between the leads 56 is made more finer. The leads 56 are formed integrally with the board member 50, thereby obviating a tie bar.

## Description

The present invention relates to a sheet-like board member, a lead frame, and a method of manufacturing a semiconductor device, and more particularly, to solution of various problems inherent to a known lead frame.

Since a circuit device to be mounted on an electronic device has conventionally been adopted by a portable cellular phone or a portable computer, demand exists for realization of a more compact circuit device of lower-profile and lighter weight.

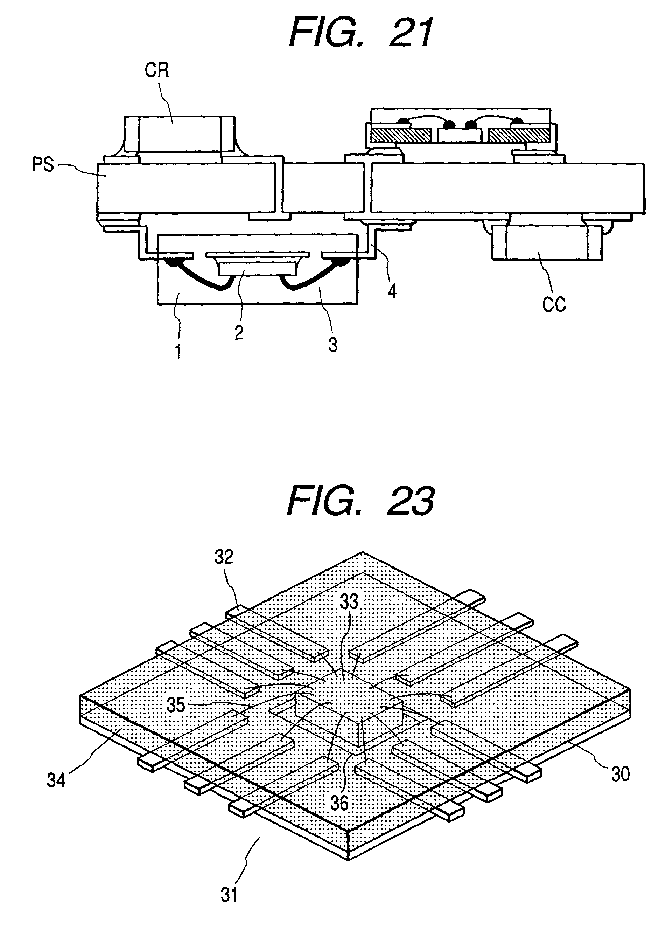

A semiconductor device is taken as an example of a circuit device. A common semiconductor device includes a semiconductor package sealed by means of transfer molding. As shown in FIG. 21, a semiconductor device 1 of this type is to be mounted on a printed board PS.

In the semiconductor package 1, a semiconductor chip 2 is encapsulated in a plastic layer 3, and leads 4 for external connection purpose are led from the sides of the plastic layer 3.

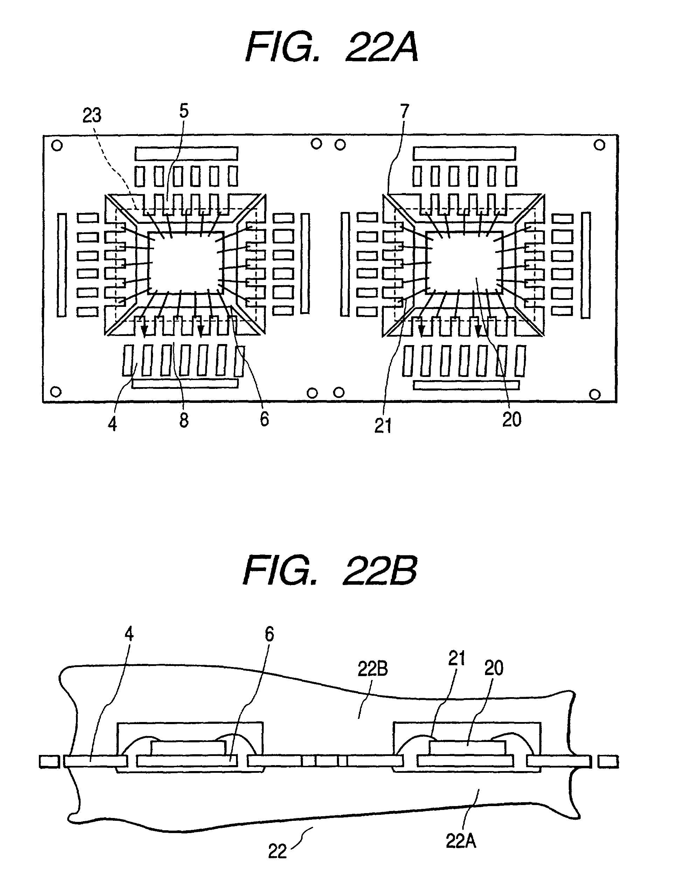

FIGS. 22A and 22B show the lead frame 5 used in the semiconductor package 1. A lead frame 5 is made of a thin metal plate formed of Cu or the like and generally assumes a rectangular exterior shape. Reference numeral 6 assigned to the center of the lead frame 5 designates an island on which the semiconductor chip 2 is to be mounted. Further, reference numeral 7 designates a suspension lead. The island 6 and the leads 4 are easily deformed by the pressure at which the resin layer 3 used for encapsulating the semiconductor chip 2 is transferred. In order to prevent deformation of the island 6 and the leads 4, the suspension leads 7 and tie bars 8 are provided. The leads 4, the island 6, the suspension leads 7, and the tie bars 8 are formed by means of the punching technique, such as a pressing technique, or by means of the etching technique.

These techniques are described in, for example, Japanese Patent Laid-Open Nos. 181241/1997 and 135230/1995. The lead frame employed for these inventions are described as a lead frame for dual-in-line packaging (DIP) purpose and a lead frame for quad-inline packaging (QIP) purpose, respectively.

In the case of the semiconductor package 1, forming a fine pattern from the leads 4, the island 6, the suspension leads 7, and the tie bar 8 is difficult, and miniaturization of the lead frame itself is difficult. Moreover, the leads 4 are led out of the plastic layer 3, which makes the entire semiconductor package 1 large. Therefore, formation of a more compact semiconductor package of lower profile and lighter weight cannot be satisfactorily achieved.

Semiconductor device manufactures have competed for realizing a more compact semiconductor package of lower profile and lighter weight and have developed various structures. Recently, a chip-size package (CSP) has been developed. More specifically, there have been developed a CSP whose wafer is equal in size with a chip, and a CSP which is slightly larger than a chip.

FIG. 23 shows a CSP 31 which employs a flexible sheet 30 as a support board and is slightly larger than a chip.

A plurality of leads 32 are laid on the surface of the flexible sheet 30. One end of each of the leads 32 is positioned in proximity to a chip-mount area where a semiconductor chip 33 is to be mounted, and the other end of the lead 32 is exposed to the outside of a plastic layer 34. Each of electrodes of the semiconductor chip 33 mounted in the chip-mount area is connected to each of the leads 32 by using (through )a fine metal wire 35. As shown in FIG. 23, an opening 36is formed in the flexible sheet 30 in order to expose the underside of the semiconductor chip 33.

There will now be briefly described a method of molding the semiconductor chip using the lead frame 5, by reference to FIGS. 22A and 22B. As shown in FIG. 22A, the lead frame 5 is first punched into a desired shape, and a semiconductor chip 20 is mounted on the island 6. Each of bonding pads provided on the semiconductor chip 20 is electrically connected to one end of each of the leads 4 by means of a bonding wire 21.

As shown in FIG. 22B, the lead frame 5 is placed in a metal mold 22. More specifically, the lead frame 5 is sandwiched between an upper metal mold 22B and a lower metal mold 22A, and insulating resin is poured into a cavity defined between the upper metal mold 22B and the lower metal mold 22A. Thus, there is formed a desired semiconductor package. The area enclosed by broken lines shown in FIG. 22A designates a molded section 23 formed from insulating resin.

Problems inherent to a semiconductor package using the lead frame 5 will now be described. The lead frame 5 is formed by means of punching material from front to back through use of the pressing technique or through use of the etching technique. In order to prevent leads and islands of the lead frame 5 from coming apart, the leads 4 are connected to the tie bar 8, and each of the islands 6 is provided with the suspension leads 7. The tie bar 8 and the suspension leads 7 are not required originally and are to be removed after molding of the lead frame 5.

The lead frame 5 is punched from front to back by means of etching or pressing, and hence a limitation is imposed on miniaturization of a lead pattern. In a case where the lead frame 5 is formed by means of, for example, punching, a pitch between leads 4 to be punched is said to be limited to a width substantially equal to the thickness of the lead frame 5. In a case where the lead frame 5 is formed by means of etching, the lead frame 5 is etched to a depth corresponding to the thickness of the lead frame 5 in both the longitudinal and lateral directions. Therefore, the pitch between leads is said to be limited to the thickness of the lead frame 5.

When an attempt is made to miniaturize the pattern of the lead frame 5, the thickness thereof must be reduced. If the thickness of the lead frame 5 itself is reduced, the strength of the lead frame 5 is also reduced, which may in turn cause problems such as warpage of the lead frame 5 or deformation and misregistration of the leads 4. Particularly, since the end of the lead 4 to be connected to the bonding wire 21 is not supported, the end of the lead 4 may cause warpage or deformation.

Further, the areas designated by arrows designate the portions of the leads 4 which protrude from the side surfaces of a semiconductor package, and burrs may arise in these areas.

As mentioned above, miniaturization of the lead frame 5 encounters limitation, thereby hindering further miniaturization of the overall semiconductor package. From the viewpoint of processes, there may be required a method of preventing warpage of the lead frame 5, a step of removing burrs, and a necessity of removing the suspension leads 7 and the tie bar 8, thereby complicating manufacturing processes.

In a case where the lead frame 5 is formed from a flexible sheet, the lead frame 5 is formed primarily by means of the etching technique, and hence such a lead frame 5 is comparatively suitable for miniaturization of a lead frame.

In a case where a lead frame punched into a desired pattern from front to back is laminated on a flexible sheet, there is a necessity for use of a tie bar and suspension leads for preventing coming apart of leads.

According to a method under which a Cu foil is laminated on a flexible sheet and the pattern of a lead frame is defined by means of etching the lead frame, the bonding strength of leads is deteriorated by an etchant, or there arises exfoliation of leads or misregistration of leads. Since leads are led to the outside of a semiconductor package, there arises a problem of resin burrs developing between leads. Further, the flexible sheet 30 serving as a support board is originally unnecessary. According to a known method, the flexible sheet has been adopted as a support board on which leads are to be laminated, and hence elimination of the flexible sheet 30 cannot be achieved. Adoption of the flexible sheet 30 adds to costs, and the thickness of the flexible sheet 30 makes a circuit device thick. Thus, the known method has encountered limitation in reducing the size, profile, and weight of a semiconductor package.

In some cases, an electrode is provided on either side of the flexible sheet, and through holes are required for interconnecting the electrodes. In this case, additional processes are added to manufacturing processes, thereby rendering the manufacturing processes longer.

The present invention intends to obtain semiconductor device having fine and highly accurate characteristics.

The present invention has been conceived in light of the foregoing problems and solves the problems by means of providing a sheet-like board member including a first planar surface and a second planar surface provided opposite the first surface, comprising:
protuberances which are formed on the second surface and are substantially identical with a plurality of leads, in which one end of each of the leads is provided in proximity to a semiconductor element mounting region.

The present invention also provides a sheet-like board member comprising a surface of the protuberances are covered with conductive coating film

Preferably, the sheet-like board member for lead frame according to claim 1, wherein said protuberances are made of conductive coating film.

Preferably, the conductive coating film is formed in at least an electrical connection portion of each of the leads.

Leads and islands can be subjected to half-etching by using conductive coating films as a mask. Further, a pitch between leads can be made smaller, by means of stopping pressing or etching of the board member at an intermediate position, without involvement of full pressing or etching of the board member from front to back . Thus, a finer pattern can be formed. Since leads or leads and islands are integrally formed with the board member, warpage or deformation of leads can be prevented, thereby obviating a tie bar of leads or suspension leads. Moreover, after the board member has been fully encapsulated in insulating plastic, leads or islands can be separated by means of abrading or etching the underside of the board member. As a result, leads or islands can be placed in predetermined positions without involvement of positional displacements. Even when leads are routed over a long distance, the leads can be placed in position without involvement of any problem. In a case where the lead frame is subjected to half-etching while being coated with a photoresist film in place of a conductive coating film, a conductive coating film pattern must be formed in at least an area of each of the leads corresponding to a bonding pad. The conductive coating film enables electrical connection of the lead to a bonding wire.

Preferably, the other end of each of the leads is located within an area which is to be encapsulated in insulating plastic.

All the leads are placed within an area on the lead frame to be encapsulated in resin, and hence there can be prevented occurrence of burrs, which would otherwise arise between leads.

Preferably, the conductive coating film patterns which are substantially identical with guide pins or guide holes into which the guide pins are to be inserted are formed in mutually-opposing sides of the sheet-like board member.

Since the pattern of guide holes identical in shape with guide pins is formed, the pattern of guide holes can be opened for guide pins when the board is encapsulated in insulating plastic. So long as the pattern of guide holes is formed for guide pins beforehand, the pattern can be set in guide pins provided on a sealing metal mold.

Preferably, the sheet-like board member is formed from a conductive foil, and the conductive coating film is formed from material differing from that of the conductive foil.

In a case where the board member is primarily formed from Cu and where a conductive coating film is made of Ni, Ag, or Au, the conductive coating mask can be utilized as an etching mask. Moreover, in a case where the board member is subjected to half-etching, the side surfaces of leads or islands can be formed so as to assume a curved structure, or a reversely-tapered structure can be form in the vicinity of the surface of respective lead or island from the conductive coating film. Thus, the half-etched board member is imparted with an anchoring effect.

A lead frame including a first planar surface and a second planar surface provided opposite the first surface, wherein protuberances which are formed on the second surface and are substantially identical with a plurality of leads, in which one end of each of the leads is provided in proximity to a semiconductor element mounting region.

The present invention also provides a lead frame comprising:
a plurality of leads which are to be electrically connected to a semiconductor element and are formed on a sheet-like board member in the form of protuberances(convex portions) by means of being subjected to half-etching.

A pitch between leads can be made smaller, by means of stopping pressing or etching of the board member at an intermediate position, without involvement of full pressing or etching of the board member from front to back. Thus, a finer pattern can be formed.

The present invention further provides a lead frame comprising:
a sheet-like board member including a first planar surface and a second planar surface on which protuberances of desired heights are formed and which is provided opposite the first planar surface, wherein the protuberances constitute a plurality of leads such that the end of each of the leads is located in proximity to a semiconductor element mounting region.

Preferably, the leads are formed by half etching.

Preferably, the leads are formed by half pressing.

Preferably, a plurality of leads formed from the protuberances are taken as a unit, and the unit is arranged on the sheet-like board member in a matrix pattern.

A pitch between leads can be made smaller, by means of stopping pressing or etching of the board member at an intermediate position, without involvement of full pressing or etching of the board member from front to back. Thus, a finer pattern can be formed. Since leads or leads and islands are integrally formed with the board member, warpage or deformation of leads can be prevented, thereby obviating a tie bar of leads or suspension leads. Moreover, after the board member has been fully encapsulated in insulating plastic, leads or islands can be separated by means of abrading or etching the underside of the board member. As a result, leads or islands can be placed in predetermined positions without involvement of positional displacements. Even when leads are routed over a long distance, the leads can be placed in position without involvement of any problem.

Preferably, in an area corresponding to the semiconductor element mounting region, the protuberance constitutes an island which is substantially the same level with or higher than the lead.

Islands can be formed without use of suspension leads. Further, islands are formed so as to become lower than the leads, or formation of islands can be omitted. As a result, the height of a semiconductor chip can be lowered, thereby rendering the overall thickness of a semiconductor package thin.

Preferably, the plurality of leads formed from the protuberances and the island are taken as a unit, and the unit is arranged on the sheet-like board member in a matrix pattern.

Preferably, the island is formed so as to be enclosed by the ends of the leads.

Preferably, a plurality of semiconductor element mounting regions are provided within the unit.

So long as a plurality of semiconductor element mounting regions are provided in a lead frame, there can be realized formation of a low-profile multi-chip semiconductor package.

Preferably, the sheet-like board member is formed from Cu, Al, an Fe-Ni alloy, a Cu-Al multilayered member, or an Al-Cu-Al multilayered member.

Preferably, a conductive coating film which is formed from material differing from that of the protuberances is formed on the upper surface of each of the leads.

Preferably, the side surface of each of the protuberances has an anchoring structure.

Preferably, the conductive coating film constitutes a reversely-tapered structure in the vicinity of a top surface of the respective lead.

Preferably, the conductive coating film is formed from Ni, Au, Ag, or Pd.

In a case where the board member is primarily formed from Cu and where a conductive coating film is made of Ni, Ag, or Au, the conductive coating mask can be utilized as an etching mask. Moreover, in a case where the board member is subjected to half-etching, the side surfaces of leads or islands can be formed so as to assume a curved structure, or a reversely-tapered structure can be form in the vicinity of the surface of respective lead or island from the conductive coating film. Thus, the half-etched board member is imparted with an anchoring effect.

Preferably, at least a portion of the leads is placed in the semiconductor element mounting region.

If a portion of leads is placed within the semiconductor element mounting region, a face-down semiconductor chip can be mounted on the lead frame. Further, there can be manufactured a BGA-type semiconductor device.

Preferably, the conductive coating film patterns which are substantially identical with guide pins are formed in mutually-opposing sides of the sheet-like board member.

Preferably, guide holes into which the guide pins are to be inserted are formed in mutually-opposing sides of the sheet-like board member.

The present invention provides a method of forming a semiconductor device comprising: the steps of;
preparing a sheet-like board member including a first planar surface and a second planar surface provided opposite the first surface, comprising protuberances which are formed on the second surface and are substantially identical with a plurality of leads, in which one end of each of the leads is provided in proximity to a semiconductor element mounting region;
mounting an semiconductor element on the protuberance on the second surface;
molding so as to cover the semiconductor element accompanied with the with second surface; and
removing the sheet-like board member so as to reach a bottom of the protuberances from the first surface , thereby dividing the protuberances of the sheet-like board member to form a plurality of leads.

Preferably, the step of removing comprises the step of etching the sheet-like board member without mask.

Preferably, the step molding comprises
the steps of:
placing the sheet like member on which the semiconductor element is mounted, in a metal mold; and
filling, with resin, the spaced defined between the sheet like member and an upper metal mold of the metal mold.

A pitch between leads can be made smaller, by means of stopping pressing or etching of the board member at an intermediate position, without involvement of full pressing or etching of the board member from front to back. Thus, a finer pattern can be formed. Since leads or leads and islands are integrally formed with the board member, warpage or deformation of leads can be prevented, thereby obviating a tie bar of leads or suspension leads. Moreover, after the board member has been fully encapsulated in insulating plastic, leads or islands can be separated by means of abrading or etching the underside of the board member. As a result, leads or islands can be placed in predetermined positions without involvement of positional displacements. Even when leads are routed over a long distance, the leads can be placed in position without involvement of any problem.

Preferably, a portion of the underside of the lead frame which is to be encapsulated in plastic is wholly brought into contact with a lower metal mold.

Preferably, vacuum suction means are distributed over the portion of the lower metal mold which is brought into contact with the underside of the lead frame.

The half-etched lead frame formed integrally with leads is brought into contact with a lower metal mold, wherewith the sheet-like lead frame can be stably positioned. As a result, bonding energy exerted on bonding wires can be supplied to the leads, thereby enabling highly-strong connection.

Preferably, wherein the step of mounting comprising a wire bonding step.

Preferably, the step of mounting comprising a direct bonding step.

Preferably, a plurality of leads which are taken as a unit are arranged on the lead frame in a matrix pattern, and the lead frame is separated on a per-unit basis.

By means of the foregoing methods, a semiconductor package is formed from leads or conductive paths such as leads and islands, a semiconductor, and insulating plastic for encapsulating the leads and the semiconductor element. Therefore, the present invention enables realization of a more compact semiconductor package which is of lower profile. Since the conductive paths are embedded, there can be realized a semiconductor package in which exfoliation of the conductive paths from insulating plastic is prevented. A conductive coating film is formed on the surface of a conductive foil, thereby enabling formation of leads and islands, in which a reversely-tapered structure is formed in the vicinity of the surface of the lead and the surface of the island. Thus, the lead frame can be embedded in insulating plastic while an anchoring effect is imparted to the lead frame.

Preferably, the conductive paths are made of pressed metal.

In the present invention, since a plate like member is used as a conductive plate for forming conductive path pattern and an isolation trench is formed by half punching or half etching to form conductive paths, conductive paths whose sheet resistance is very low, whose pattern is fine and whose surface is very flat, can be obtained.

Therefore, bonding reliability is very high and in the case of mounting a high-integrated semiconductor circuit, high accuracy and reliability in the high-integrated semiconductor circuit device can be realized.

According to using a pressed metal as a conductive plate, boundaries are positioned at random, thereby sheet resistance is low and fine and very flat conductive paths in microscopic views can be obtained.

In the case that plating film whose thickness is formed so thick as to be able to use as conductive paths, film thickness is deviated and a sufficient flatness cannot be obtained. For example, when a plating film whose thickness is 20-35 *µ* m is formed, it is difficult to have an uniform thickness of the plating film. Therefore bonding strength is lowered.

Contrary that, in the case if conductive paths formed by half etching a pressed metal such as copper foil, the surface of the conductive paths is very flat and bonding accuracy and bonding reliability are very high.
In the plating film, according to using a mirror polished surface of a substrate as a growth starting face of plating, then removing the substrate and using the growth starting face as a bonding face, flatness of the bonding surface is slightly improved. However accuracy in the case is inferior to use the pressed metal such as cooper.

The invention also provides a semiconductor device manufactured in accordance with the method, or including a lead frame in accordance with the invention.

The invention will be further described by way of example with reference to the accompanying drawings, in which:-
FIGS. 1A and 1B are schematic representations for describing a sheet-like board member according to the present invention;
FIGS. 2A and 2B are schematic representations for describing a method of manufacturing a semiconductor device which employs the sheet-like board member or lead frame according to the present invention;
FIGS . 3A and 3B are illustrations for describing a method of manufacturing a semiconductor device which employs the sheet-like board member or lead frame according to the present invention;
FIG. 4 is a schematic representation for describing a sheet-like board member according to the present invention;
FIG. 5 is a schematic representation for describing a method of manufacturing a semiconductor device which employs the sheet-like board member or lead frame according to the present invention;
FIGS. 6A and 6B are illustrations for describing a method of manufacturing a semiconductor device which employs the sheet-like board member or lead frame according to the present invention;
FIGS. 7A and 7B are schematic representations for describing a sheet-like board member according to the present invention;
FIGS. 8A and 8B are schematic representations for describing a lead frame according to the present invention;
FIGS. 9A and 9B are illustrations for describing a method of manufacturing a semiconductor device which employs the sheet-like board member or lead frame according to the present invention;
FIGS. 10A and 10B are illustrations for describing a method of manufacturing a semiconductor device which employs the sheet-like board member or lead frame according to the present invention;
FIGS. 11A through 11c are illustrations for describing a method of manufacturing a semiconductor device which employs the sheet-like board member or lead frame according to the present invention;
FIGS. 12A through 12C are illustrations for describing a method of manufacturing a semiconductor device which employs the sheet-like board member or lead frame according to the present invention;
FIG. 13 is a schematic representation for describing a lead frame according to the present invention;
FIG. 14 is a schematic representation for describing a lead frame according to the present invention;
FIGS. 15A and 15B are schematic representations for describing a lead frame according to the present invention;
FIG. 16 is a schematic representation for describing a lead frame according to the present invention;
FIG. 17 is a schematic representation for describing a lead frame according to the present invention;
FIGS. 18A and 18B are illustrations for describing a method of manufacturing a semiconductor device which employs the sheet-like board member or lead frame according to the present invention;
FIGS. 19A and 19B are illustrations for describing a method of manufacturing a semiconductor device which employs the sheet-like board member or lead frame according to the present invention;
FIGS. 20A and 20B are illustrations for describing a method of manufacturing a semiconductor device which employs the sheet-like board member or lead frame according to the present invention;
FIG. 21 is a cross-sectional view for describing the structure of a known semiconductor device mounted on a board;
FIGS. 22A and 22B are illustrations for describing a method of manufacturing a semiconductor device employing a known lead frame; and
FIG. 23 is a perspective view for describing a semiconductor device employing a flexible sheet as a support board.

### First Embodiment for Describing a Sheet-like Board Member and a Lead frame

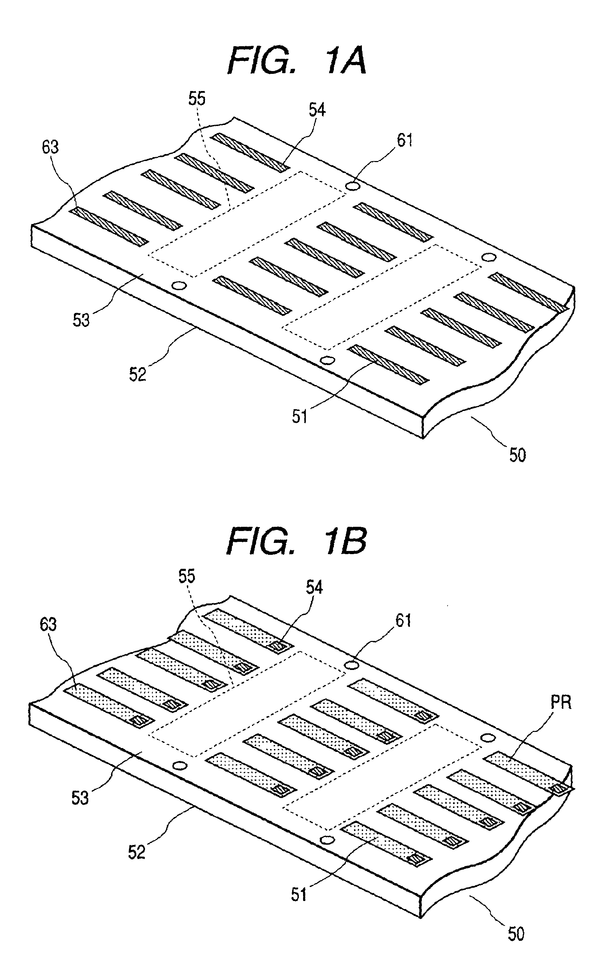

FIGS. 1A and 1B show a sheet-like board member 50. The sheet-like board member 50 is superior to a known lead frame in terms of sealing a semiconductor element and can embody a lower-profile package.

The sheet-like board member 50 shown in FIG. 1A corresponds to a known lead frame for use in, for example, a single-inline package (SIP), a dual-inline package (DIP), or a quad-inline package (QIP), when the pattern of a lead frame is formed on a sheet-like conductive foil as a conductive coating film 51 while islands are removed from the pattern of a lead frame (hereinafter often referred to as a "lead frame pattern").

The sheet-like board member 50 comprises a first surface 52 which is planar and a second surface 53 which is provided opposite the first surface 52 and is also planar. On the second surface 53, there are provided a plurality of conductive coating films 51 which are substantially identical with a plurality of leads 56. The leads 56 are provided such that one end 54 of each of the leads 56 is located in proximity to a semiconductor element mounting region 55.

In place of the conductive coating films 51, etching-resistant masks, such as photoresist films, may be formed on the sheet-like board member 50. For example, as shown in FIG. 1B, photoresist (PR) films may be formed in the locations where the leads 56 are to be formed. In this case, there is a necessity for forming the conductive coating film 51 in at least the end 54 of the lead in order to enable wire bonding or soldered connection.

The present invention is characterized in adoption of the sheet-like board member. As will be evident from the following description, the sheet-like board member 50 is subjected to half etching by using the conductive coating film 51 or a photoresist film as a mask. A semiconductor element 57 is mounted on the thus-etched sheet-like board member 50 and is encapsulated in insulating plastic 58. The exposed portions of the sheet-like board member 50 placed on the back of the insulating plastic 58 are processed by means of etching, abrasion, or grinding until the leads 56 are separated on a per-semiconductor-element basis. As a result, a semiconductor package can be constituted of three materials; namely, the semiconductor element 57, the plurality of leads 56, and the insulating plastic 58 for encapsulating the leads 56. The sheet-like board member 50 can finally act as a lead frame.

The principal characteristic of the present invention lies in that the sheet-like board member 50 is in a state in which it can be subjected to half-etching.

Etching reaction usually takes place in both vertical and horizontal directions. This phenomenon becomes particularly noticeable in the case of isotropic etching, in which the vertical depth of etching becomes substantially identical with the horizontal length of etching. In the case of anisotropic etching, the horizontal length of anisotropic etching is much shorter than that of isotropic etching. In any event, anisotropic etching involves occurrence of horizontal etching reaction.

In a case where a lead frame is formed by etching material from front to back, the areas between the leads 56 are etched horizontally. Therefore, the pitch between the leads 56 cannot be made smaller than a certain limiting value, thus rendering formation of a minute pattern difficult.

However, if the conductive coating films 51 are formed on the sheet-like board member 50 as the patterns of the leads 56 and if the sheet-like board member 50 is subjected to half-etching, the vertical depth of etching can be made smaller, thereby reducing the horizontal length of etching. As a result, formation of a lead frame having a finer pattern can be achieved.

For example, the conductive coating films 51 made of Ni, Ag, Pd or Au are patterned on the sheet-like board member 50 of 2 ounces (70 µm). The sheet-like board member 50 is isotropically etched until the conductive coating films 51 are completely etched away, to thereby produce leads 56. The pitch between the thus-produced leads 56 is the narrowest pitch; that is, the pitch assumes a value of substantially 70 *µ*m. In a case where the sheet-like board member 50 is etched to a depth of 35 *µ*m while the conductive coating films 51 are utilized as etching-resistant masks, the pitch between the leads 56 can be made narrow, to a value of substantially 35 µm. As a result, the packaging efficiency of a semiconductor package can be doubled, wherewith formation of a finer pattern can be embodied. The shallower the depth to which the sheet-like board member 50 is to be etched, the finer a pattern becomes.

The sheet-like board member 50 may correspond to a multilayer member made of Cu-Al or Cu-Al-Cu.

In view of etching facilities, productivity, and manufacturing costs, the sheet-like board member 50 is preferably subjected to wet etching. Wet etching is non-anisotropic etching. In a comparatively large number of cases, wet etching is transverse etching. For this reason, half-etching of the sheet-like board member 50 by using the conductive coating films 51 as a mask is superior in terms of formation of fine patterns of the leads 56.

The leads 56 are formed integrally with the sheet-like board member 50, by means of half-etching of the sheet-like board member 50 by using the conductive films 51 as a mask, thereby obviating the necessity of forming a tie bar. Therefore, there can be eliminated a process of removing a tie bar after encapsulation of the semiconductor element 57 in the insulating plastic 58.

In the case of the lead frame 5 of known structure shown in FIGS. 22A and 22B, the leads 4 suspended by the tie bar 8 are completely punched through and patterned. Therefore, there may arise misregistration or warpage of the leads 4. However, the leads 4 are formed integrally with the sheet-like board member 50. So long as the sheet-like board member 50 is fixed, neither misregistration nor warpage of the leads 4 arises. Thus, the present invention has a characteristic of providing the ability to stably bond a bonding wire to the end 54 of each of the leads 56.

If guide holes 61 are formed in the sheet-like board member 50, the guide holes 61 will be convenient for placing the sheet-like board member 50 into metal molds.

Circular conductive coating films which are substantially identical in shape with guide pins are patterned in corresponding positions on the sheet-like board member 50. Before molding of the sheet-like board member 50, the guide hole 61 maybe formed by means of drilling, punching, or etching the circular patterns. Alternatively, there may be used a sheet-like board member 50 having guide holes 61 formed therein. The sheet-like board member 50 can be molded with high accuracy by means of inserting guide pins of the metal molds into the guide holes 61.

As mentioned above, the leads 56 are formed by means of half-etching the sheet-like board member 50 as a mask the conductive coating films 51. The thus-formed leads 56 may be adopted as a lead frame.

A semiconductor device manufacturer usually performs pre-processing operations in one facility, and post-processing operations in another facility. The facility designed for post-processing operations is not equipped with an etching apparatus. So long as a lead frame manufacturer supplies sheet-like board members to a semiconductor manufacturer while the board members are in a half-etched state, the semiconductor manufacturer can manufacture a semiconductor device through molding of a board member without use of an etching apparatus.

The lead 56 may be substantially identical in size with or larger than a bonding pad.

### Second Embodiment for Describing a Method of Manufacturing a Semiconductor Device adopting a Sheet-Like Boarding Member or a Lead frame

Manufacture of a semiconductor device 60 employing use of the sheet-like board member 50 or a lead frame will be described by reference to FIGS. 1 through 3B.

First, as shown in FIGS. 1A and 1B, the sheet-like board member 50 is prepared. A first surface 52 and a second surface 53 are planar, and etching-resistant masks are formed on the second surface 53 in the form of lead patterns. FIG. 1A shows the sheet-like board member 50 in which there are formed the conductive coating films 51 substantially identical in shape with the leads 56. FIG. 1B shows the sheet-like board member 50 in which photoresist (PR) films are formed in lieu of the conductive coating films 51. In a case where the photoresist (PR) films are adopted, a conductive coating film must be formed in at least areas on the sheet-like board member 50 corresponding to bonding pads. (see FIG. 1 for the foregoing description).

Subsequently, the sheet-like member 50 is subjected to half-etching by using the conductive coating films 51 or the photoresist (PR) films as a mask. The depth to which the sheet-like member 50 is to be etched is smaller than the thickness of the sheet-like member 50. The shallower the depth of etching of the sheet-like member 50, the finer the lead patterns can be formed.

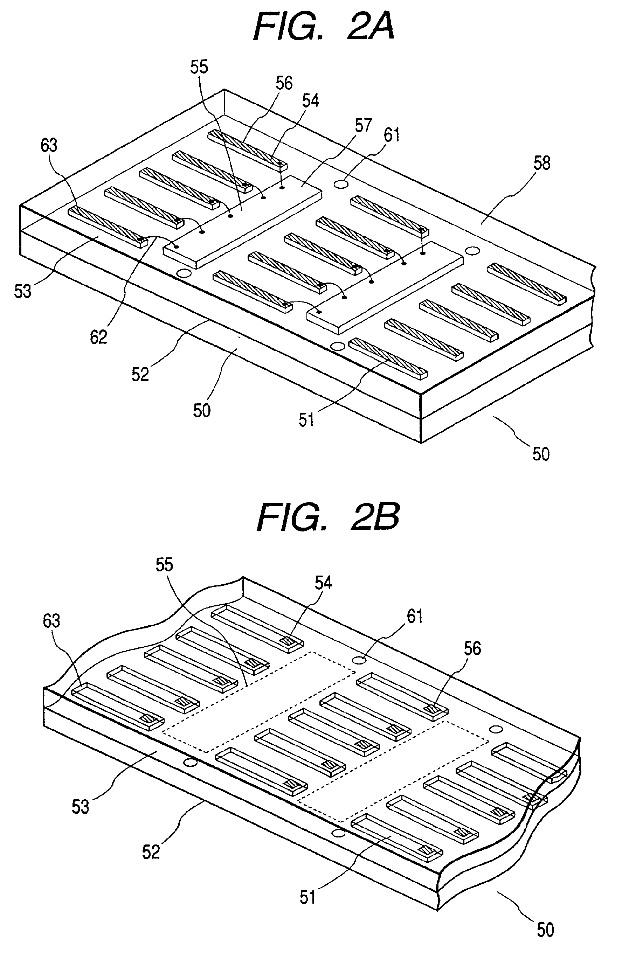

As a result of the sheet-like board member 50 being subjected to half-etching, the leads 56 appear on the second surface 53 of the board member 50. As a result of the board member 50 shown in FIG. 1A being subjected to half-etching, there is obtained the board member shown in FIG. 2A. If the board member 50 shown in FIG. 1B is subjected to half-etching, the board member 50 shown in FIG. 2B is obtained.

For example, in a case where a semiconductor manufacturer has an etching apparatus installed in a facility for performing a post-processing process, the semiconductor manufacturer purchases the board members 50 shown in FIG. 1A or 1B from a lead frame manufacturer. In contrast, if a semiconductor manufacturer does not has any etching apparatus installed in a facility for post-processing processes, the semiconductor manufacturer can purchase lead frames which have already been etched and in which leads are formed in the form of protuberances on the surface of the board member. In this way, a semiconductor manufacturer can readily proceed to the following manufacturing processes without involvement of introduction of an etching apparatus. Further the lead frame can be formed by half pressing.

Next, the semiconductor element 57 is fixedly mounted on the semiconductor element mounting region 55, and bonding pads of the semiconductor element 57 are electrically connected to the corresponding ends 54 of the leads 56. In the drawings, the semiconductor element 57 is mounted face up, and hence bonding wires 62 are adopted as connection means.

During the bonding operation, the leads 56 are integrally formed with the sheet-like board member 50, and the back of the sheet-like board member 50 is in contact with the surface of a table of a bonding machine. If the sheet-like member 50 is completely fixed on the table of the bonding machine, heat is transferred well to the table. Further, bonding energy can be efficiently transferred to the bonding wires 62 and the leads 56 without involvement of misregistration of the leads 56. The sheet-like board member 50 can be fixed on the table of the bonding machine, by means of forming, for example, a plurality of vacuum suction holes over the entire surface of the table.

In the case of adoption of a face-down semiconductor element, solder balls or bumps made of Au or solder are formed on electrodes of the semiconductor element 57, and the leads 56 are arranged such that the ends 54 of the leads 56 are located directly beneath the solder balls or bumps. The ends 54 and the solder balls or bumps are connected together.

The semiconductor element 57 is encapsulated in the insulating plastic 58 such that the leads 56, the semiconductor element 57, and the connection means are completely covered.

In a case where the sheet-like board member 50 is encapsulated through use of metal molds, the guide holes 61 are formed in the sheet-like board member 50 during this manufacturing step. Guide pins of the metal molds are inserted into the corresponding guide holes 61, wherewith the sheet-like board member 50 is placed in position with high accuracy. Since the first surface 52 of the sheet-like board member 50 is planar, the surface of a lower metal mold with which the back of the board member 50 is brought into contact is also formed planar.

The insulating plastic 58 is poured into the metal mold, and may be either thermoplastic insulating material or thermosetting insulating material.

The sheet-like board member 50 can be encapsulated in the insulating plastic 58 by means of transfer molding, injection molding, dipping, or coating. Thermosetting resin, such as epoxy resin, can be used as plastic material for transfer molding purpose. Thermoplastic resin such as liquid-crystal polymer, polyphenylene sulfide, or the like can be used as plastic material for injection molding purpose.

In the present embodiment, the insulating plastic 58 is controlled so as to be built to a thickness of about 100 µm from the top of the bonding wires 62. The thickness of the insulating plastic 58 can be increased or decreased in consideration of strength of a semiconductor device.

Since the leads 56 are formed integrally with the sheet-like board member 50, positional displacement of the leads 56 does not arise at all, unless the board member 50 otherwise includes positional displacement. Even in this case, the sheet-like member 50 can be fixed on a lower metal mold by means of vacuum suction.

The leads 56 formed in the form of protuberances and the semiconductor element 57 are encapsulated in the insulating plastic 58. The portion of the board member 50 located below the leads 56 is exposed on the back of the plastic resin 58 (see FIGS. 2A and 2B).

Subsequently, the exposed portion of the board member 50 on the back of the insulating plastic 58 is removed, whereupon the leads 56 are separated into pieces.

Separation of the lead 56 of the board member 50 is considered to be effected in various ways. For example, the back of the board member 50 may be removed by means of etching, by means of abrasion or grinding, or by means of a combination thereof. If the back of the board member 50 is ground until the insulating plastic 58 becomes exposed, shavings of the board member 50 or burr-like metal flakes extending outside of the board member 50 are engaged in the insulating plastic 58. In order to prevent occurrence of such a problem, grinding of the board member 50 is stopped before exposure of the insulating plastic 58. Subsequently, the leads 56 are separated into pieces by means of etching, thereby preventing metal of the board member 50 from being engaged in the insulating plastic 58 located between the leads 56. Thus, occurrence of an electrical short circuit in a minute space defined between leads can be prevented.

During a half-etching operation, variations arise in the thickness to which the insulating plastic 58 is etched. In order to prevent occurrence of such variations, the insulating plastic 58 is ground to a target thickness by means of abrasion or grinding after the leads 56 have been separated into pieces by means of etching, thereby producing a semiconductor package of given thickness.

In a case where a plurality of units are fabricated on the board member 50, each unit to act as a semiconductor device 60, the units are separated into individual semiconductor devices 60.

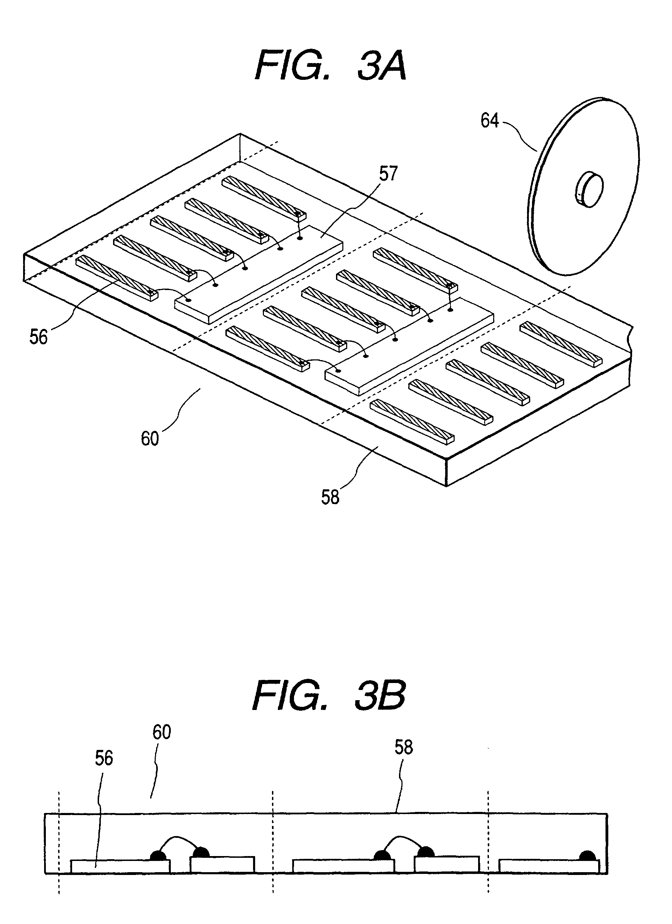

Although the units are separated into pieces by means of adoption of the dicing machine 64, the units can be separated by means of breaking perforations, pressing, or cutting. In FIGS. 3A and 3B, separation lines are indicated by broken lines . FIGS. 3A and 3B show separation of the leads 56 shown in FIG. 2A, and illustration of separation of the leads 56 shown in FIG. 2B is omitted (see FIGS. 3A and 3B).

The foregoing manufacturing method enables realization of a smaller and lower-profile semiconductor package through use of three elements; the plurality of leads 56, the semiconductor element 57, and the insulting plastic 58.

Advantages yielded by the manufacturing method will now be described.

The board member 50 or a lead frame is subjected to half-etching, thereby producing the leads 56 in the form of protuberances, thereby enabling formation of a fine pattern of leads. Accordingly, the width of leads and a pitch between leads can be made smaller, thereby enabling formation of a semiconductor package having a smaller in-plane size.

Second, since a semiconductor package is formed from three elements, the semiconductor package can be formed from the required minimum number of elements , thus reducing needless material to a minimum. Accordingly, there can be embodied a low-profile semiconductor package whose costs are minimized.

Third, the leads 56 are formed in the form of protuberances through half-etching, thereby obviating a necessity for use of a tie bar formed between leads. Accordingly, the present invention completely eliminates a necessity for forming and cutting a tie bar.

Fourth, after the leads formed in the form of protuberances have been encapsulated in insulating plastic, a sheet-like board member is removed from the reverse side of the insulating plastic, and the leads are separated into pieces . In contrast with a semiconductor package of known structure, no plastic burrs arise between leads. Consequently, there can be obviated a step of removing burrs from a molded package.

Fifth, the reverse side of a semiconductor element becomes exposed through the back of the insulating plastic 58, and hence the heat developing in the semiconductor device can be dissipated from the back of the semiconductor device.

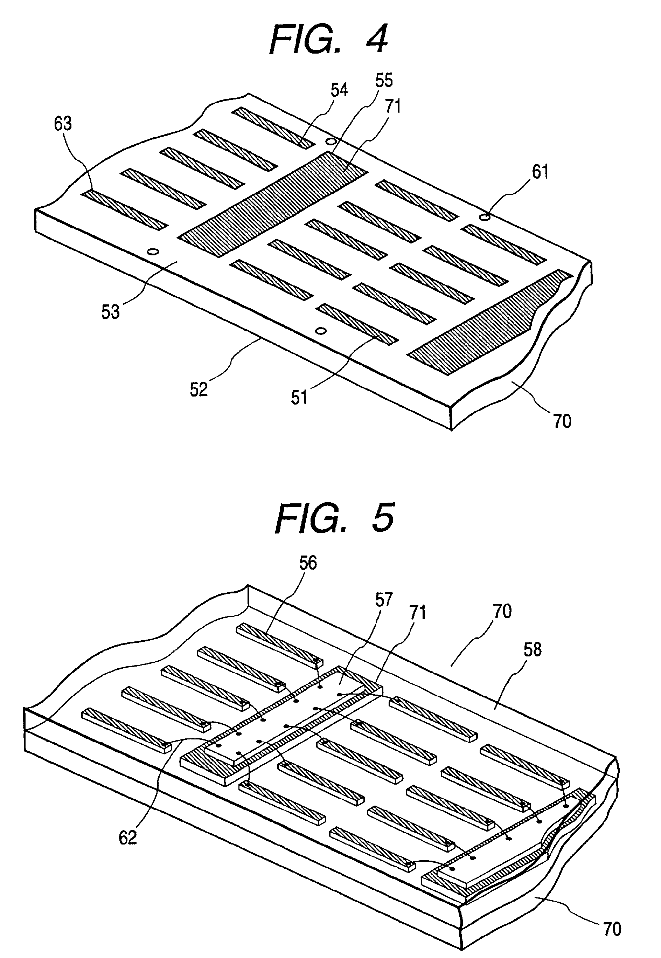

Sixth, in contrast with the board member shown in FIG. 4 to be described later, no island is provided in a semiconductor element mounting region, and hence the top surface of a semiconductor element can be lowered. As a result, the profile of a semiconductor package can be made correspondingly lower.

### Third Embodiment for Describing a Sheet-Like Board Member and Lead frame

FIG. 4 shows an improvement in the sheet-like board member 50 or lead frame shown in FIG. 1, such that islands 71 are added to the board member 50 or lead frame.

Explanation will be given of only the additional islands 71. Those elements which are the same as those shown in FIGS. 1 through 3B are assigned the same reference numerals.

As shown in FIG. 4, a sheet-like board member 70 has a pattern which is substantially identical with that of a known lead frame. For instance, the pattern of leads of, for example, an SIP, DIP, or QIP and the pattern of the islands 71 are formed from the conductive coating films 51.

The sheet-like board member 70 comprises a first planar surface 52 and a second planar surface 53 provided opposite the first surface 52. A plurality of conductive coating films 51 are provided on the second surface 53 and are substantially identical with a plurality of leads 56 such that the ends 54 of the leads 56 are located in proximity to the semiconductor element mounting region 55. A conductive coating film 51-which is substantially identical with the island 71 on which the semiconductor element 57 is to be mounted-is formed in the semiconductor element mounting region 55.

In a subsequent step, the areas on the lead frame except for the islands 71 and the leads 56 to be formed are subjected to half-etching. The surfaces of the protruding islands 71 are formed flat without being etched. Thus, the semiconductor element 57 can be placed substantially horizontally.

The protruding island 71 is encapsulated in the insulating plastic 58, and the undersides of the islands 71 are exposed through the insulating plastic 58. Thus, the moisture resistance of the semiconductor element 57 can be improved.

Since the islands 71 are formed integrally with the board member 70, use of suspension leads can be obviated.

As is evident from the present embodiment, the areas on the lead frame except for the area the islands 71 and the leads 56 to be formed are subjected to half-etching by using the conductive coating films 51 as a mask. The leads 56 and the islands 71 are formed protuberantly.

As mentioned in the previous embodiments, the lead frame can be supplied to a post-processing process in which no etching apparatus is provided, so that a semiconductor package can be manufactured through use of existing facilities.

As shown in FIG. 1B and 2B, a photoresist film may be adopted in lieu of a conductive coating film. In this case, a conductive coating film is formed in at least an area on the photoresist film corresponding to a bonding pad.

### Fourth Embodiment for Describing a Method of Manufacturing a Semiconductor Device Employing a Sheet-Like Board Member or Lead frame

Processes up to and including a process for manufacturing a semiconductor device 60 from the sheet-like member 70 are described by reference to FIGS. 4 through 6.

The method is essentially identical with that described in connection with the second embodiment, except for use of the islands 71. Hence, the method will be described briefly.

The sheet-like board member 50 is prepared as shown in FIG. 4. Both the first surface 52 and the second surface 53 are planar, and the conductive coating films 51 identical in shape with the pattern of the leads 56 and the conductive coating films 51 identical in shape with the pattern of the islands 71 are formed on the second surface 53 (see FIG. 4).

Subsequently, the sheet-like board member 70 is subjected to half-etching by using the conductive coating films 51 as a mask. The shallower the depth of etching, the finer the pattern that can be formed.

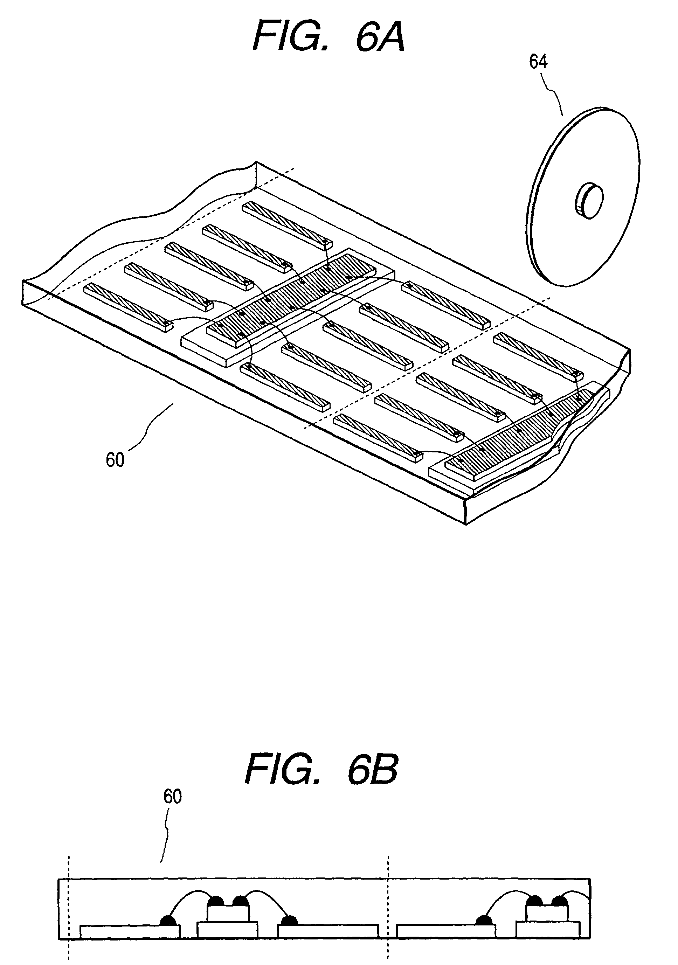

As shown in FIG. 5, as a result of the sheet-like board member 70 being subjected to half-etching, the leads 56 and the islands 71 appear in the form of protuberances on the second surface 53 of the board member 70. In the present invention, the board member 70 in this state is called a lead frame. A lead frame manufacturer may supply lead frames in such a state to a semiconductor manufacturer.

The semiconductor element 57 is mounted on each of the islands 71 formed in the corresponding semiconductor element mounting region 55. Electrodes of the semiconductor element 57 are electrically connected to the corresponding ends 54 of the leads 56. Since the semiconductor elements 57 are mounted face up, the bonding wire 62 is employed as connection means.

Subsequently, the insulating plastic 58 is formed. The insulating plastic may be either thermoplastic insulating resin or thermosetting insulating resin.

The insulating plastic 58 encapsulates the leads 56, the islands 71, and the semiconductor element 57, wherein the leads 56 and the islands 71 are formed protuberantly. The sheet-like board member 70 with which the leads 56 and the islands 71 are formed integrally is exposed on the back of the insulating plastic 58 (see FIG. 5).

Subsequently, the sheet-like board member 70 exposed on the underside of the insulating plastic 58 is removed, and the leads 56 encapsulated in the insulating plastic 58 are separated into pieces.

In a case where a single unit-which is to be finally separated into semiconductor devices 60-is formed into a matrix pattern, the unit is separated into individual semiconductor devices 60 (see FIGS. 6A and 6B).

The foregoing method enables manufacture of a low-profile and smaller semiconductor package from four elements; that is, the plurality of leads 56, the islands 71, the semiconductor elements 57, and the insulating plastic 58.

Advantages yielded by the method will now be described.

First, the leads 56 and the islands 71 are formed on the board member 70 by means of half-etching, and hence a miniaturized lead frame pattern can be realized. In other words, the width of the lead 56, a pitch between the leads 56, and an interval between the lead 56 and the island 71 can be made smaller. Consequently, there can be formed a semiconductor package which is more compact when viewed from the top 8i.e., which has a smaller in-plane size).

Second, a semiconductor package is formed from the four elements, and hence the semiconductor package can be formed from the required minimum number of elements, thus reducing needless material to a minimum and diminishing costs significantly.

Third, the leads 56 are formed through half-etching and separated into pieces after encapsulation, thereby obviating use of a tie bar formed between leads. Accordingly, the present invention completely eliminates a necessity for forming and cutting a tie bar. In other words, the present invention can completely obviate formation and cutting of a tie bar and suspension leads.

Fourth, after the leads formed through half-etching have been encapsulated in insulating plastic, a sheet-like board member is removed from the back of the insulating plastic, and the leads are separated into pieces. In contrast with a semiconductor package of known structure, no plastic burrs arise between leads. Consequently, there can be obviated a step of removing burrs from a molded package.

Fifth, the underside of a semiconductor element becomes exposed through the back of the insulating plastic 58, and hence the heat developing in the semiconductor device can be dissipated from the back of the semiconductor device. As compared with a semiconductor package described in connection with the first embodiment, the semiconductor package has improved moisture resistance.

### Fifth Embodiment for Describing a Sheet-Like Board Member

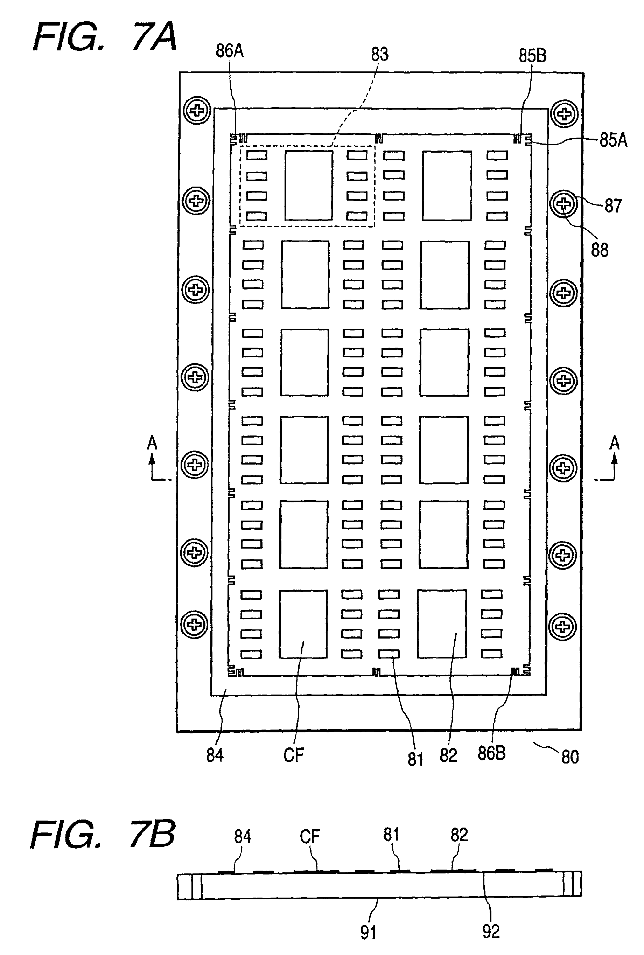

FIGS. 7A and 7B show a sheet-like board member 80 which is formed from conductive coating films CF (or photoresist films) in the same manner as the sheet-like board members described in connection with the first and third embodiments. The geometry of the sheet-like board member 80 will be described in detail in connection with a sixth embodiment, and hence only the outline of the sheet-like board member 80 will be described here.

The lead frame pattern shown in FIG. 7A corresponds to a specific embodiment of the lead frame patterns shown in FIGS. 1 through 4. More specifically, a plurality of pattern units 83, each constituting a single semiconductor device from a plurality of leads 82 and an island 82, are formed into a matrix arrangement. A metal mold abutting region 84 is formed in a ring shape and to a predetermined width so as to enclose the matrix arrangement. FIGS. 7A and 7B show patterns which are to be formed within a single cavity.

Register marks 85 and 86 are formed at positions located inward the mold abutting region 84. An imaginary line interconnecting a register mark 85A and a register mark 86A indicates a lateral dicing line, and an imaginary line interconnecting a register mark 85B and a register mark 86B indicates a longitudinal dicing line. One of the register marks 85A is printed in the form of at least one short line. The orientation of a blade of a dicing machine is aligned with reference to the short line 85A. The register mark 85A is formed from two lines which are spaced a desired interval (margin) from each other, such that the blade can dice with a desired accuracy.

First patterns 87 and second patterns 88 are formed outside the metal mold abutting region 84 for forming guide holes. A cross sign of the second pattern 88 is a centering mark to be used for drilling a guide hole. Alternatively, guide holes-which are identical in shape with the first pattern-are formed in a pattern beforehand, without involving formation of the pattern.

In a case where the pattern is formed from photoresist films in lieu of conductive coating films, conductive coating films are formed in at least areas below the photoresist films corresponding to bonding pads.

The sheet-like member 80 is identical with those described in connection with the first and third embodiments, with the exception of the dicing line marks and the metal mold abutting region 84. Hence, explanation of the characteristics and advantages of the present embodiment is omitted. Sixth Embodiment for Describing a Lead frame

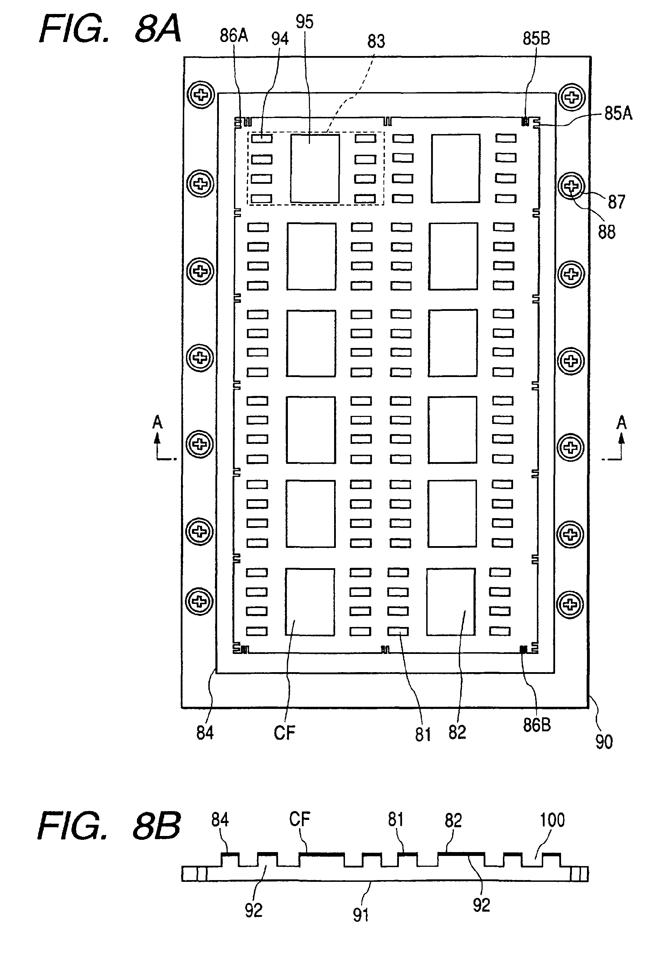

A lead frame 90 according to a sixth embodiment of the present invention assumes a pattern shown in FIGS. 8A and 8B. The lead frame 90 is subjected to half-etching by using the conductive coating films CF (or photoresist films) as a mask described in connection with the fifth embodiment.

More specifically, the lead frame 90 corresponds to a known lead frame when the known lead frame is formed by means of subjecting the pattern of, for example, an SIP, DIP, or QIP, to half-etching exclusive of the islands 82, the leads 81, and the metal abutting region 84. In contrast with the first embodiment, the present embodiment can obviate formation of the islands 82. The first register marks 87 and the second register marks 88 may be formed into protuberances by means of half-etching.

The lead frame 90 comprises a first planar surface 91 and a second surface 92 which is provided opposite the first surface 91 and on which protuberances 92 are formed to desired heights.

The protuberances 92 constitute a plurality of leads 81 whose tip ends 94 are provided in proximity to respective semiconductor element mounting regions 95.

In the lead frame 90, respective patterns are in a half-etched state. In an unmodified form of the lead frame 90, a semiconductor element can be mounted, electrically connected, and encapsulated. Thus, the present embodiment has a characteristic of providing the ability to manufacture a semiconductor package in a post-processing process through use of existing apparatus.

Since the advantages of the present embodiment have already been described in connection with the first through fifth embodiments, repeated explanation is omitted here.

### Seventh Embodiment for Describing a Method of Manufacturing a Semiconductor Device

A method will be described by reference to FIGS. 7 through 12.

As shown in FIGS. 7A and 7B, the sheet-like board member 80 is prepared. The material of the sheet-like board member 80 is determined in consideration of the adhesive properties, bonding properties, and plating properties of brazing material. More specifically, a conductive foil primarily made of Cu, a conductive foil primarily made of Al, or a sheet-like conductive foil made of a alloy such as Fe-Ni alloy is employed as the material of the sheet-like board member 80. Alternatively, the board member may be made of a Cu-Al multilayered member or a Cu-Al-Cu multilayered member. Particularly, a Cu-Al-Cu multilayered member is preferable, because it can prevent warpage of the board member 80, which would otherwise be caused by a difference in coefficients of thermal expansion between layers of a multilayered member.

The leads 81, the islands 82, the metal mold abutting regions 84, the register marks 85 and 86, and the first and second patterns 87 and 88 are formed from conductive coating films.

In consideration of an etching operation to be effected in a subsequent process, a preferable thickness of a conductive foil is 10 µm to 300 µm or thereabouts. In the present embodiment, a copper foil of 70 µm thickness (or two ounces) is adopted. However, in principle there may be employed any material having a thickness less than or greater than the range of thickness from 10 µm to 300 µm (see FIGS. 7A and 7B with regard to the description thus far).

Subsequently, the method comprises a step of etching the sheet-like board member 80, with exclusion of at least areas of the board member 80 which are to become the leads 81, the islands 82, the metal mold abutting region 84, and the register marks 85 and 86.

Here, the conductive coating films CF are used as etching-resistant masks, and isolation trenches 100 are formed shallower than the thickness of the sheet-like board member 80.

According to the present method, the board member 80 is non-anisotropically etched by means of wet or dry etching, and the side surfaces of leads or islands become rough and curved.

In the case of a wet etching, ferric chloride or cupric chloride is adopted as an etchant. The conductive foil is dipped in the etchant, or the etchant is showered on the conductive foil.

Etching encounters difficulty in proceeding in a horizontal direction at a position immediately below the conductive coating film CF which is to act as an etching mask. For this reason, an area deeper than the conductive coating film CF is etched horizontally. For this reason, the isolation trench 100 assumes a reversely-tapered structure. More specifically, the width of the top of the isolation trench 100 becomes smaller than the width of the same at a certain depth. In other words, the isolation trench 100 assumes an anchor structure. By means of adoption of a showering method, etching proceeds in a depthwise direction, and horizontal etching is retarded. Thus, an anchor structure becomes noticeable.

In the case of dry etching, the sheet-like board member 80 can be etched anisotropically or non-anisotropically. Although removal of Cu through reactive ion etching (RIE) has been said to be impossible, Cu can be removed by means of sputtering. Depending on conditions for sputtering, the sheet-like board member 80 can be etched anisotropically or non-anisotropically.

In FIGS. 8A and 8B, a photoresist film which is corrosion-resistant to an etchant may be selectively used for coating in lieu of the conductive coating film CF. So long as areas which are to become conductive paths are selectively coated with a photoresist film, an isolation trench can be etched without adoption of a conductive coating film.

Materials considered for adopting as a conductive coating film include Ag, Au, Pt, or Pd. These corrosion-resistant conductive coating films have a characteristic of being able to be utilized in unmodified form as islands or bonding pads.

For example, an Ag coating film is bonded to Au or a brazing material. Therefore, so long as the underside of a semiconductor chip is coated with an Au coating film, the semiconductor chip can be mounted on an Ag coating film covering the island 82, through thermocompression bonding. Alternatively, the semiconductor chip can be mounted on the island 82 by using a brazing material such as solder as a mask. Since an Au fine line can be bonded to an Ag conductive coating film, a semiconductor chip can be mounted on the island 82 by means of wire bonding. Thus, the present method has a merit of providing the ability to utilize the conductive coating film in an unmodified form as a die pad or bonding pads (see FIGS. 8A and 8B).

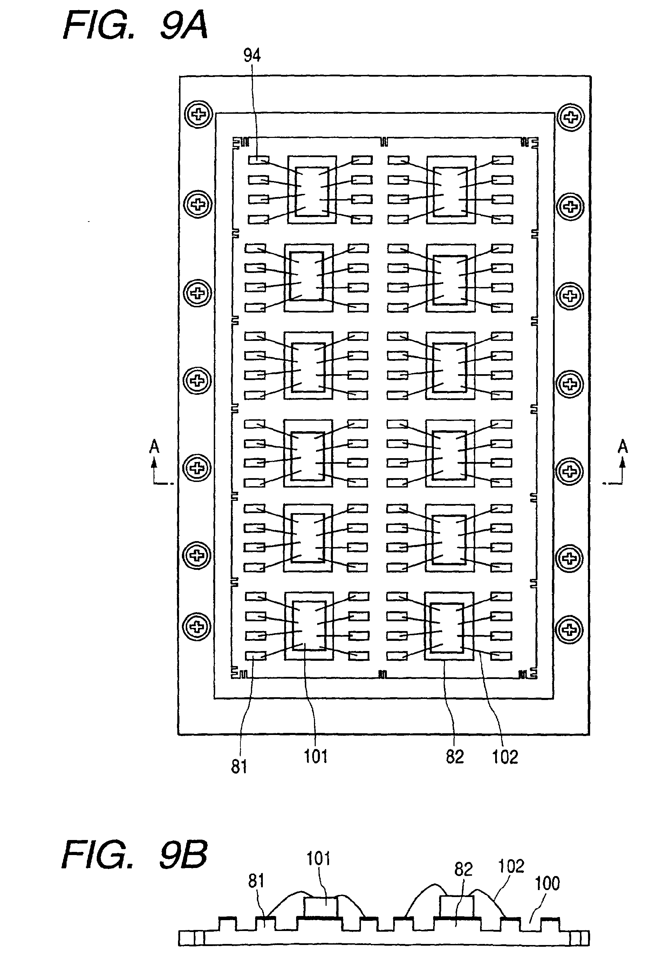

As shown in FIGS. 9A and 9B, there is carried out a process of mounting a semiconductor element 101 on the island 82 in which the isolation trenches 100 are formed.

The semiconductor element 101 corresponds to a transistor, a diode, an IC chip, or the like. Further, an SMD (a face-down semiconductor element), such as a CSP or BGA of wafer-scale type, can also be mounted. However, in this case, a resultant semiconductor package assumes a large thickness.

In the present embodiment, a bare IC 101 is die-bonded to each of the islands 82. Bonding pads provided on the IC 101 are connected to ends 94 of the leads 81 by using bonding wires 102 by means of ball bonding using thermocompression bonding, or by means of wedge bonding using ultrasonic waves.

Since the leads 81 are integrally formed with the sheet-like board member 80 and can transmit the energy imparted by a bonding tool, the bonding characteristic of the leads 81 is improved. Therefore, the leads 81 can be made small. In some cases, the bonding wires 102 are subjected to pull-cutting after bonding. At this time, since the bonding pads are integral with the board member 80, floating of bonding pads can be prevented, and hence the ease of pull-cutting of metal wires can be improved (see FIGS. 9A and 9B with regard to the description thus far).

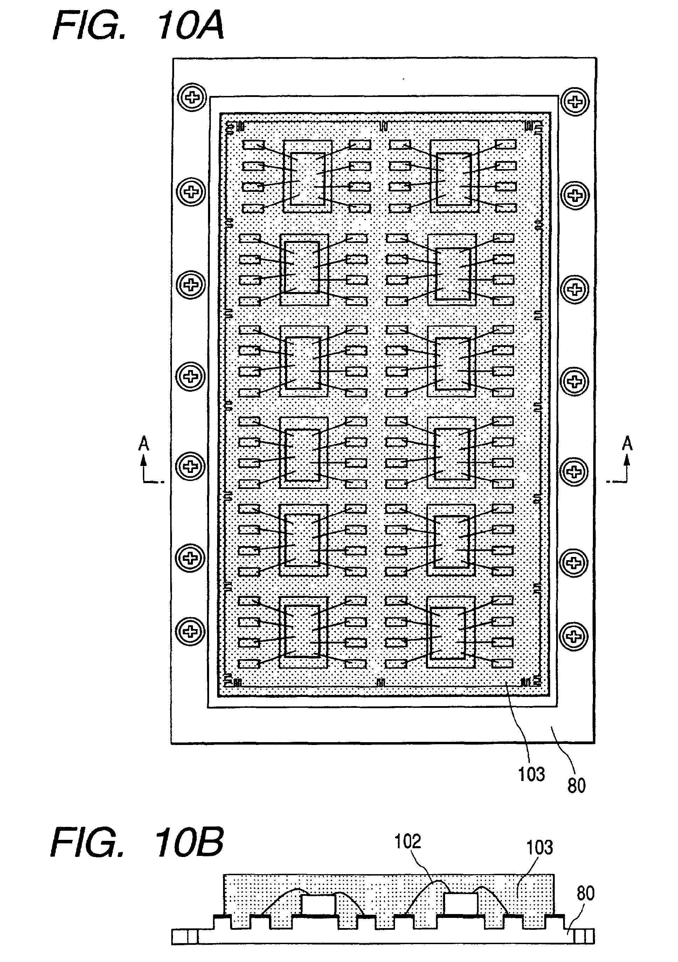

As shown in FIGS. 10A through 11C, there is carried out a process of applying insulating plastic 103 to the isolation trenches 100 by means of transfer molding, injection molding, dipping, or coating. Thermosetting resin, such as epoxy resin, can be used as plastic material for transfer molding purpose. Thermoplastic resin, such as liquid-crystal polymer, polyphenylene sulfide or the like, can be used as plastic material for injection molding purpose.

In the present embodiment, the insulating plastic 103 is controlled so as to be built up to a thickness of about 100 µm from the top of the bonding wires 102. The thickness of the insulating plastic 58 can be increased or decreased in consideration of strength of a semiconductor device.

The present process is characterized in that the sheet-like board member 80 acts as a support board until the isolation trenches 100 are filled with the insulating plastic 103 and the insulating plastic 103 cures. A support board, such as a glass epoxy board, a flexible sheet, or a ceramic board, has conventionally been required. However, the present invention can obviate such a support board.

Since the isolation trenches 100 having a curved structure are filled with the insulating plastic 103, the thus-filled portion of the isolation trenches 100 produces an anchoring effect, thereby preventing exfoliation of the leads 81 or island 82 from the insulating plastic 103.

Before the isolation trenches 100 are coated with the insulating plastic 103, silicon resin or the like may be potted in order to protect a semiconductor chip or connected portions of bonding wires.

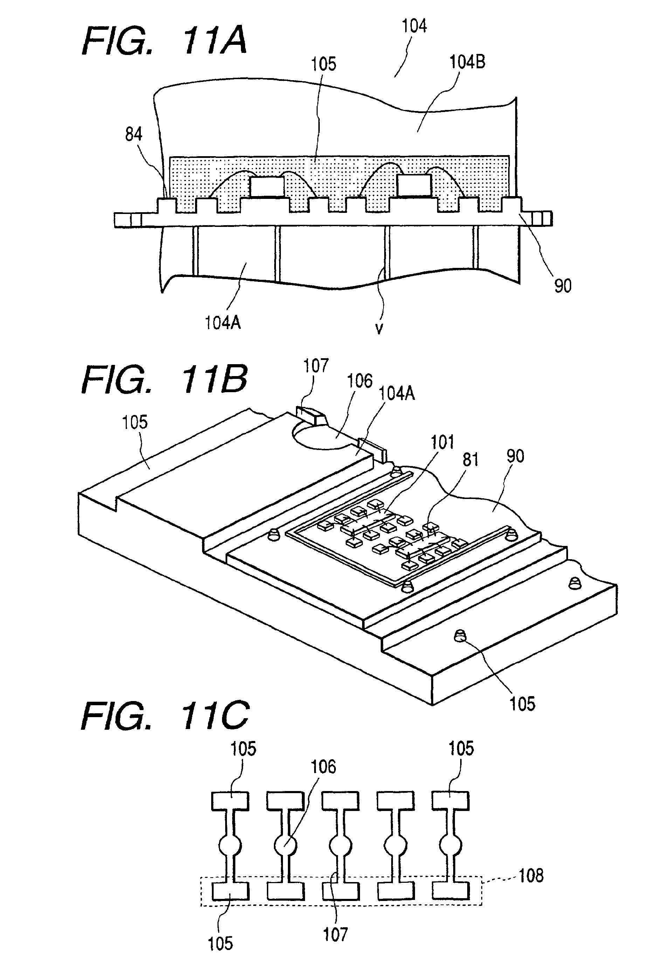

FIGS. 11A and 11B illustrate a molding method. FIG. 11a is a cross-sectional view showing plastic charged into the cavity 105 defined within the metal mold 104. The entire underside of the lead frame 90 is found to remain in contact with the lower metal mold 104A, and the upper metal mold 104B is found to be in contact with the mold abut region of the lead frame 90. Reference symbol V designates a vacuum suction hole. FIG. 11B designates the lower metal mold 104A on which the lead frame 90 is fixed. Reference numeral 105 designates guide pins provided on the lower metal mold 104A. The guide pins 105 jut from the guide holes formed in the lead frame 90.

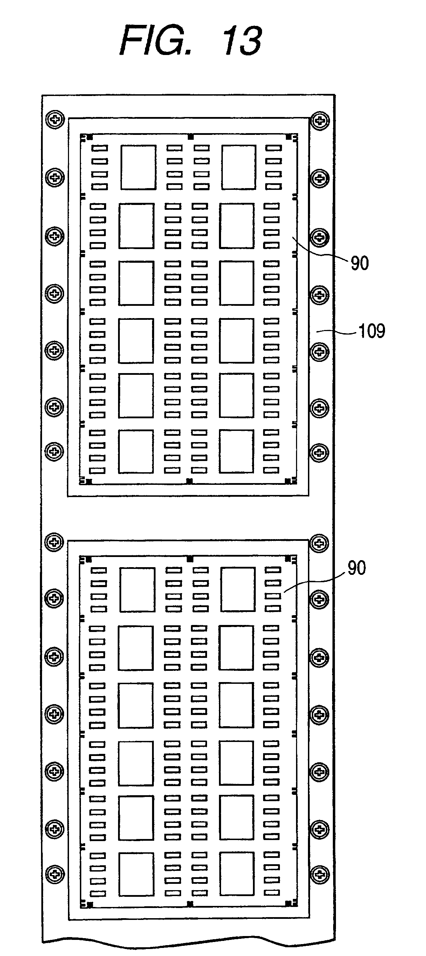

FIG. 11C is an explanatory view for describing the relationship between the cavity 105 defined within the metal mold 104, a runner 107, and a pot 106. As shown in the drawing, a plurality of cavities 105 are arranged in a horizontal direction, so that a plurality of semiconductor devices can be formed from a single lead frame. Reference numeral 108 indicated by broken lines designates an area in which a lead frame is to be arranged (hereinafter referred to simply as a "lead frame arrangement area") . For example, a lead frame 109 shown in FIG. 13 is placed in the lead frame arrangement area 108. The lead frame 109 corresponds to a plurality of lead frames 90 shown in FIG. 8 formed integrally. Semiconductor devices are compact and can be formed within a single cavity 105. Thus, semiconductor devices can be mass-produced, thereby resulting in reduction of manufacturing costs (see FIGS. 10A through 11C with regard to the description thus far).

In a subsequent step, the molded lead frame 109 is taken out of the metal mold 104, and an exposed portion of the sheet-like board member 80 on the underside of the insulating plastic 103 is removed. The leads 81 and the islands 82 are then separated.

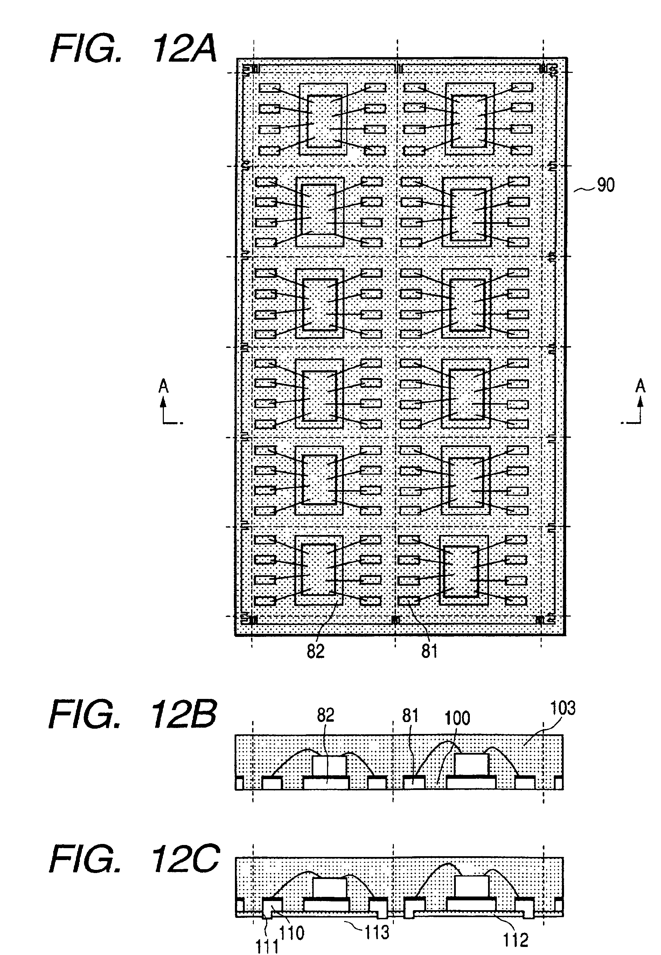

FIG. 12A is a plan view showing separation lines, and FIG. 12B shows that the underside of the insulating region 103 is on the same level with the undersides of the leads 81, and that the underside of the insulating region 103 is on the same level with the undersides of the islands 82. An insulating coating film, such as a solder resist, may be formed on the underside of the insulting region 103, and it may be the case that only the portions of the underside which must be electrically connected may be exposed.

FIG. 12C shows the leads 81 when abrasion of the leads 81 is stopped at an intermediate position, as a result of which a protuberance 111 is formed on the other end 110 of each of the leads 81. More specifically, the protuberance 111 can be formed by means of forming a photoresist film on an area of the lead 81 which is to become a protuberance 111, and etching the lead 81 other than the area covered with the photoresist film. An insulating coating film 112 is formed on the underside of the insulating plastic 103 such that the protuberances 111 become exposed, thereby preventing occurrence of an electrical shortcircuit between a conductor provided on a board and the island 82 located above the conductor. In a case where a semiconductor chip is mounted on the island 82 by using a brazing material, there can be prevented contact between the leads 81 and the island 82, which would otherwise be caused by spreading of solder melt to the leads 81. Particularly, the insulating coating film 112 becomes more effective as the pattern of leads 81 becomes narrower.

Finally, the thus-molded lead frame 90 is placed on a dicing table, and the position of a blade is adjusted with reference to the register marks 85 and 86. The lead frame 90 is diced along the lines indicated by broken lines, thereby completing formation of semiconductor devices 113.

Through the foregoing processes, the underside portions of the leads 81 are exposed through the insulating plastic 103.

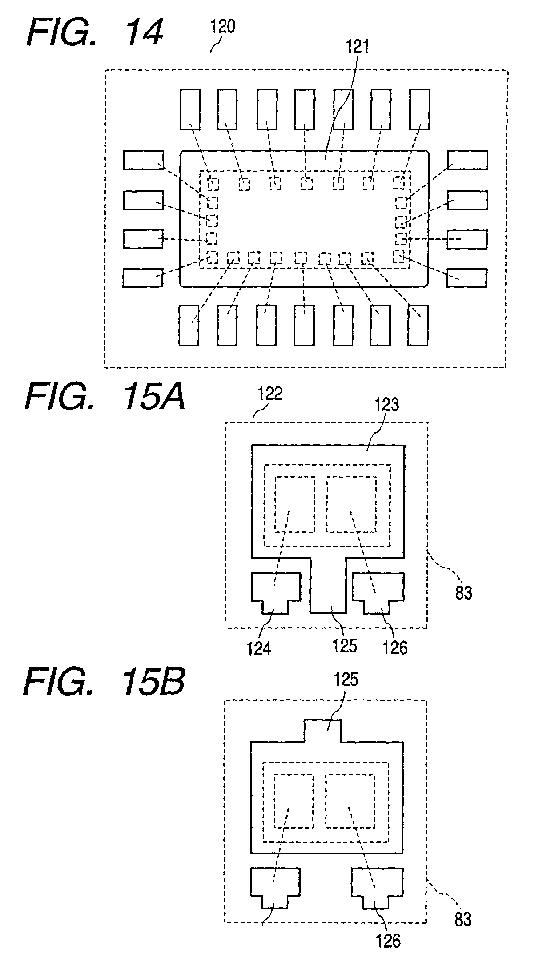

According to the present method, an IC chip is mounted on the island 82. A transistor or a diode may be mounted in place of the IC chip. Further, a plurality of semiconductor elements may be mounted. In this case, a plurality of semiconductor chips may be mounted on a single island according to the structure of a lead frame. Alternatively, a plurality of islands on which respective semiconductor chips are to be mounted may be formed on a lead frame. The patterns of such lead frames will be described by reference to FIGS. 14 through 17.

FIG. 14 shows a lead frame 120 of a QFP, and, for example, suspension leads for use with an island 121 are obviated. Particularly, in the case of a QFP, suspension leads are provided in four corners on a lead frame, as shown in FIG. 22. The suspension leads are obviated. Therefore, bonding pads can be formed on the corners. A rectangular area enclosed by broken lines denotes an area where a semiconductor chip is to be mounted (hereinafter referred to as a "semiconductor chip mount area").

FIG. 15A shows a lead frame 122 employed for a transistor. A lead 124 which is to act as an emitter, a lead 125 which is to act as a collector, and a lead 126 which is to act as a base are led from one side of the island 123.

In a case where solder balls are formed on the undersides of the leads 124 through 126 shown in FIG. 15A by using the insulating coating film 112, the leads are densely located on one side of the island 123, which in turn causes a semiconductor device to become inclined. In order to prevent inclination of a semiconductor device, the three leads 124 through 126 are arranged in a triangular pattern, as shown in FIG. 15B.

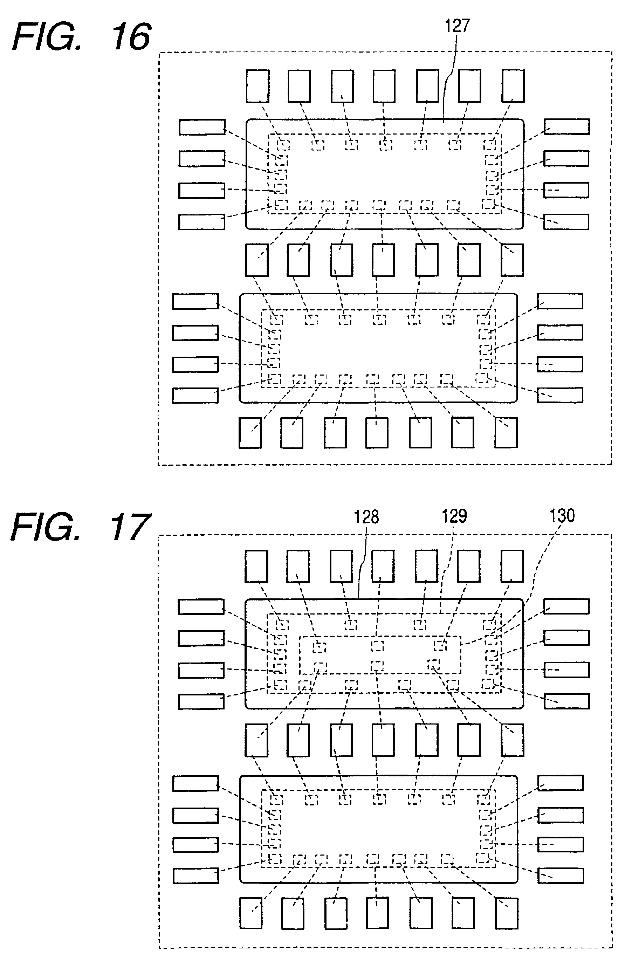

FIG. 16 depicts a lead frame on which a plurality of IC chips are mounted. Islands 127 are provided in equal number with IC chips.

FIG. 17 shows two semiconductor chips 129 and 130 when they are stacked within a desired island 128. FIGS. 16 and 17 show realization of a semiconductor device consisting of multiple chips. In a case where a multi-functional semiconductor device is realized, the lead frame according to the present embodiment is effective. Particularly, the lead frame is effective for use with a system LSI which has recently been developed. Since there is no need to design all features into a single chip, the present invention yields an advantage of significantly reducing development costs and time. Further, in a case where a semiconductor device is utilized as memory, the capacity of memory can be increased in accordance with the number of chips.

According to the present method, the leads 81 are embedded in the insulating plastic 103, wherewith there can be realized a planar semiconductor device characterized in that the underside of the insulating plastic 103 is on the same level with the undersides of the leads 81.

### Eighth Embodiment for Describing a Method of Manufacturing a Semiconductor Device

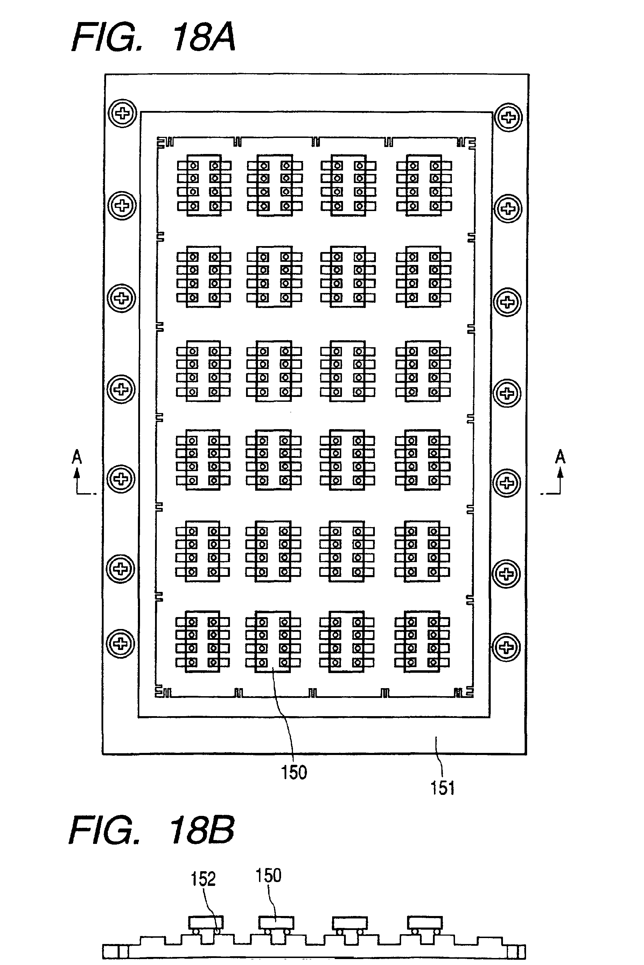

FIGS. 18A to 20B show formation of a semiconductor device by means of mounting a face-down semiconductor element 150 on a lead frame 151.

If bonding wires are used for electrically connecting bonding pads to leads, the leads will greatly extend off from a semiconductor element mounting region. However, so long as a face-down semiconductor element of the present embodiment is employed, extension of leads can be reduced or eliminated. Further, bonding wires involve high tops, which in turn results in an increase in the thickness of a semiconductor package. In contrast, so long as a face-down semiconductor element is adopted, a thin semiconductor package can be embodied.

A face-down semiconductor element adopts solder balls 152 or adopts solder bumps or gold bumps in place of the solder balls 152.

In a case where the semiconductor element 150 is mounted on the lead frame 151 through use of brazing material such as solder, there is no need to form a conductive coating film on the surfaces of leads like bonding pads, because the leads are primarily made of Cu. However, in order to produce an anchoring effect by means of forming a reversely-tapered structure, formation of a conductive coating film is necessary.

Since the manufacturing method is the same as those described in connection with the previous embodiments, the method will be described briefly.

As shown in FIGS. 18A and 18B, there the lead frame 151 is prepared, and solder balls 152 of the semiconductor element 150 are attached to the lead frame 151.

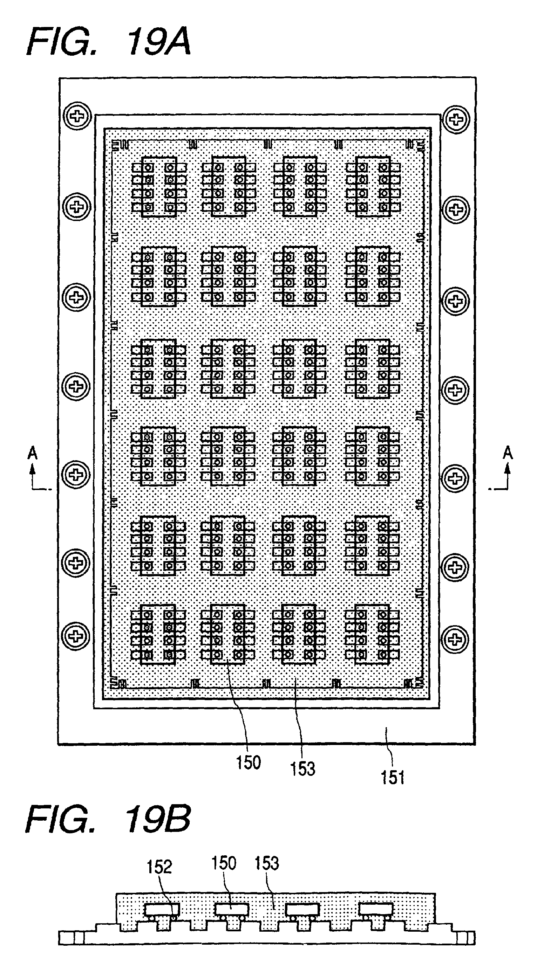

As shown in FIGS. 19A and 19B, the semiconductor element 150 is encapsulated in insulating plastic 153.

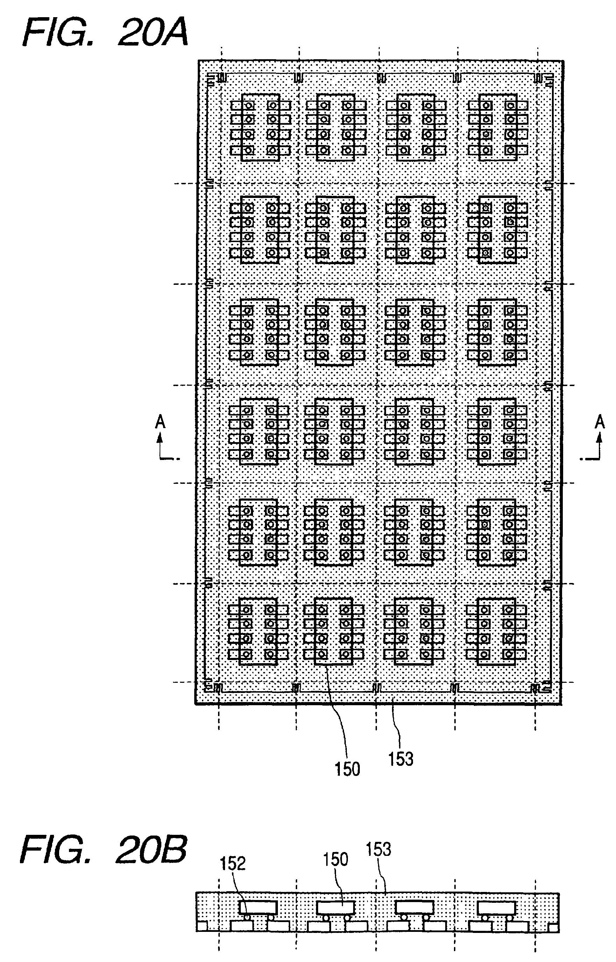

As shown in FIGS. 20A and 20B, the lead frame 151 located on the underside of the insulating plastic 153 is removed from below, thereby separating the leads. The molded lead frame 151 is diced along lines indicated by broken lines, whereby formation of semiconductor devices is completed.

A sheet-like board member is coated with a conductive coating film whose etch rate is low and is subjected to half-etching by using as a mask the conductive coating film, wherewith a reversely-tapered structure and a curved structure can be embodied. Consequently, the sheet-like board member can be imparted with an anchoring effect.

If Ni is formed over a Cu foil, Cu and Ni can be etched by a single etching operation by means of ferric chloride or cupric chloride. By virtue of a difference in etch rate between Cu and Ni , a reversely-tapered structure is formed from Ni. Thus, coating of a Cu foil with Ni is preferable.

Since the underside of a semiconductor chip is directly exposed or islands are exposed, the semiconductor chip can be thermally coupled with conductive paths laid on a board, thereby improving dissipation of heat from a semiconductor device. Accordingly, the temperature of a semiconductor chip can be reduced, and the driving performance of a semiconductor chip can be improved correspondingly.

For example, power MOSs, IGBTs, SITs, heavy-current drive transistors, and heavy-current drive IC memory elements (for example, ICs of MOS type, BIP type, and Bi-CMOS type) are preferable.

As is evident from the foregoing descriptions, a sheet-like board member according to the present invention has a structure which enables half-etching of leads and islands by using as a mask conductive coating films. Further, the sheet-like board member can be formed in the form of a lead frame, by means of stopping pressing or etching of the board member at an intermediate position, without involvement of full pressing or etching of the board member from front to back. The structure which enables half-etching contributes to a reduction in a pitch between leads and formation of a finer lead frame. Since leads or leads and islands are integrally formed with the board member, warpage or deformation of leads can be prevented, thereby obviating a tie bar of leads or suspension leads. Moreover, after the board member has been fully encapsulated in insulating plastic, leads or islands can be separated by means of abrading or etching the underside of the board member. As a result, leads or islands can be placed in predetermined positions without involvement of positional displacements . Even when leads are routed over a long distance, the leads can be placed in position without involvement of any problem.

Since the entire leads are placed within an area which is to be encapsulated in plastic, there can be prevented occurrence of burrs, which would otherwise arise between leads under the known manufacturing method.

Since the pattern of guide holes identical in shape with guide pins is formed, the pattern of guide holes can be opened for guide pins when the board is encapsulated in insulating plastic. So long as the pattern of guide holes is formed for guide pins beforehand, the pattern can be set in guide pins provided on a sealing metal mold, thereby enabling highly-precise plastic molding operation.

In a case where the board member is primarily formed from Cu and where a conductive coating film is made of Ni, Ag, or Au, the conductive coating mask can be utilized as an etching mask. Moreover, in a case where the board member is subjected to half-etching, the side surfaces of leads or islands can be formed so as to assume a curved structure, or a reversely-tapered structure can be form in the vicinity of the surface of respective lead or island from the conductive coating film. Thus, the half-etched board member is imparted with an anchoring effect. Therefore, exfoliation of leads or islands from the underside of the insulating plastic can be prevented.

Since islands are formed integrally with a board member, the islands can be formed without use of suspension leads. Further, islands are formed so as to become lower than the leads, or formation of islands can be omitted. As a result, the height of a semiconductor chip can be lowered, thereby rendering the overall thickness of a semiconductor package thin.

A semiconductor device formed from a sheet-like board member or lead frame is manufactured from the minimum required number of elements, such as a semiconductor element, conductive paths such as leads or islands, and insulating plastic. Therefore, a semiconductor device is manufactured without involvement of wastage of resources. Accordingly, there can be embodied a semiconductor device which enables a significant reduction in manufacturing costs. As a result, there can be realized a very compact semiconductor device which is of lower profile and lighter weight, by means of setting the thickness of a conductive foil to an optimum value.

Since only the undersides of conductive paths are exposed through the insulating plastic, the undersides of the conductive paths can be directly used for connection with the outside. Thus, the present invention yields an advantage of obviating formation of through holes, as the purpose of forming through holes is achieved by a flexible sheet of known structure.

In a case where a semiconductor element is mounted directly on an island by using a conductive coating film as a mask, such as a brazing material, Au, or Ag, the undersides of islands are exposed, and hence the heat developing in the semiconductor element can be transferred directly to a board by using the islands. Particularly, dissipation of heat from the semiconductor element enables mounting of a power element.

In the semiconductor device according to the present invention, the surface of an isolation trench is at substantially the same level with the surface of a lead. Therefore, even when a narrow-pitch QFP is mounted on a board, a semiconductor element can be moved in its present form in a horizontal direction. Thus, deviation of leads can be corrected very easily.

The side surfaces of leads or islands assume a curved structure, and a reversely-tapered structure is formed in the vicinity of the surface of the respective lead or island. Accordingly, the leads or islands can produce an anchoring effect, thereby preventing warpage or exfoliation of conductive paths.

The entire board member supports the semiconductor elements until molding of semiconductor elements and leads are encapsulated in insulating plastic. Accordingly, as described in connection with the background art, a support board such as a flexible sheet can be obviated, wherewith a semiconductor package can be manufactured at lower cost.

Further, removing step for dividing individual leads can be conducted by the step of etching the sheet-like board member without mask.

## Claims

1. A sheet-like board member for lead frame including a first planar surface and a second planar surface provided opposite the first surface, comprising:
protuberances which are formed on the second surface and are substantially identical with a plurality of leads, in which one end of each of the leads is provided in proximity to a semiconductor element mounting region.

2. The sheet-like board member for lead frame according to claim 1, wherein a surface of the protuberances are covered with conductive coatingfilm

3. The sheet-like board member for lead frame according to claim 1, wherein said protuberances are made of conductive coating film.

4. The sheet-like board member for lead frame according to claim 1, 2 or 3, wherein a or the conductive coating film is selectively formed in at least an electrical connection portion of each of the leads.

5. The sheet-like board member for lead frame according to claim 1, 2, 3 or 4, wherein the other end of each of the leads is located within an area which is to be encapsulated in insulating plastic.

6. The sheet-like board member for lead frame according to anyone of the preceding claims, wherein conductive coating film patterns which are substantially identical with guide pins or guide holes into which the guide pins are to be inserted are formed in mutually-opposing sides of the sheet-like board member for lead frame.

7. The sheet-like board member for lead frame according to any one of the preceding claims, wherein the sheet-like board member for lead frame is made of a conductive foil, and a or the conductive coating film is formed from material differing from that of the conductive foil.

8. A lead frame including a first planar surface and a second planar surface provided opposite the first surface, wherein protuberances which are formed on the second surface and are substantially identical with a plurality of leads, in which one end of each of the leads is provided in proximity to a semiconductor element mounting region.

9. A lead frame according to claim 8, wherein said protuberance is formed by half etching.

10. A lead frame according to claim 8, wherein said protuberance is formed by half pressing.

11. The lead frame according to claim 8, 9 or 10, wherein a plurality of leads formed from the protuberances are taken as a unit, and the unit is arranged on the sheet-like board member in a matrix pattern.

12. The lead frame according to claim 8, 9, 10 or 11, wherein, in an area corresponding to the semiconductor element mounting region, the protuberance constitutes an island which is substantially the same level with or higher than the lead.

13. The lead frame according to claim 12, wherein the island is formed so as to be enclosed by the ends of the leads.

14. The lead frame according to any one of claims 8 to 13 , wherein a plurality of semiconductor element mounting regions are provided within the unit.

15. The lead frame according to any one of claims 8 to 14, wherein the sheet-like board member is formed from Cu, Al, an Fe-Ni alloy, a Cu-Al multilayered member, or an Al-Cu-Al multilayered member.

16. The lead frame according to any one of claims 8 to 15, wherein the side surface of each of the protuberances has an anchoring structure.

17. The lead frame according to any one of claims 8 to 16, wherein a conductive coating film which is formed from material differing from that of the protuberances is formed on the upper surface of each of the leads.

18. The lead frame according to claim 17, wherein the conductive coating film constitutes a reversely-tapered structure in the vicinity of a top surface of the respective lead.

19. The lead frame according to claim 17, wherein the conductive coating film is formed from Ni, Au, Ag, or Pd.

20. The lead frame according to any one of claims 8 to 19, wherein at least a portion of the leads is placed in the semiconductor element mounting region.

21. The lead frame according to any one of claims 8 to 20, wherein conductive coating film patterns which are substantially identical with guide pins are formed in mutually-opposing sides of the sheet-like board member.

22. The lead frame according to any one of claims 8 to 21, wherein guide holes into which the guide pins are to be inserted are formed in mutually-opposing sides of the sheet-like board member.

23. A method of manufacturing a semiconductor device comprising: the steps of:
preparing a sheet-like board member including a first planar surface and a second planar surface provided opposite the first surface, comprising protuberances which are formed on the second surface and are substantially identical with a plurality of leads, in which one end of each of the leads is provided in proximity to a semiconductor element mounting region;
mounting a semiconductor element on the protuberance on the second surface;
molding so as to cover the semiconductor element

24. The method of manufacturing a semiconductor device according to claim 23, wherein the step of removing comprises the step of etching the sheet-like board member without mask.

25. The method of manufacturing a semiconductor device according to claim 23 or 24, wherein the step of moulding comprises
placing the sheet like member on which the semiconductor element is mounted, in a metal mold; and
filling, with resin, a space defined between the sheet like member and an upper metal mold of the metal mold.

26. The method of manufacturing a semiconductor device according to claim 25, wherein the step of molding comprises a step of setting a sheet like member into the metal mold so that a portion of the first surface of the sheet like member which is to be molded is wholly brought into contact with a lower metal mold: and transferring the resin into the metal mold so that the semiconductor element and whole protuberances are embedded completely.

27. The method of manufacturing a semiconductor device according to claim 23, 24, 25 or 26, wherein vacuum suction means are distributed over the portion of the lower metal mold which is brought into contact with the underside of the lead frame.

28. The method of manufacturing a semiconductor device according to any one of claims 23 to 27, wherein the step of mounting comprising a wire bonding step.

29. The method of manufacturing a semiconductor device according to any one of claims 23 to 28, wherein the step of mounting comprising a direct bonding step.

30. The method of manufacturing a semiconductor device according to any one of claims 23 to 29, wherein a plurality of leads which are taken as a unit are arranged on the lead frame in a matrix pattern, and the lead frame is separated on a per-unit basis.
